(19) Europäisches Patentamt
European Patent Office
Office européen des brevets

(11) **EP 4 095 625 A1**

(12) **EUROPEAN PATENT APPLICATION**

(43) Date of publication:
**30.11.2022 Bulletin 2022/48**

(21) Application number: **22173952.7**

(22) Date of filing: **18.05.2022**

(51) International Patent Classification (IPC):
**G05B 13/02** *(2006.01)* **G05B 13/04** *(2006.01)*

(52) Cooperative Patent Classification (CPC):
**G05B 19/41875; G05B 13/0265; G05B 13/048;**
G05B 2219/32194; G05B 2219/32201;
G05B 2219/45031

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **27.05.2021 JP 2021089253**

(71) Applicant: **Yokogawa Electric Corporation
Musashino-shi, Tokyo 180-8750 (JP)**

(72) Inventors:
• **ISHII, Masaki
Musashino-shi, Tokyo, 180-8750 (JP)**
• **ENDO, Makoto
Musashino-shi, Tokyo, 180-8750 (JP)**
• **MIYAO, Makoto
Musashino-shi, Tokyo, 180-8750 (JP)**
• **KARASAWA, Rei
Musashino-shi, Tokyo, 180-8750 (JP)**
• **TAKAMI, Go
Musashino-shi, Tokyo, 180-8750 (JP)**

(74) Representative: **Winter, Brandl - Partnerschaft
mbB
Alois-Steinecker-Straße 22
85354 Freising (DE)**

(54) **PREDICTION APPARATUS, PREDICTION METHOD, PREDICTION PROGRAM, AND CONTROL APPARATUS**

(57) Provided is a prediction apparatus including: a data acquisition unit configured to acquire setting value data indicating a setting value of a controlled object and physical quantity data indicating a physical quantity of a product obtained by controlling the controlled object; a prediction unit configured to calculate, using the setting value data and the physical quantity data, a plurality of prediction values obtained by predicting a plurality of physical quantities in the product on a basis of a setting value used for control of the controlled object; an evaluation unit configured to evaluate the plurality of prediction values on a basis of a predefined reference; and an output unit configured to output a setting value recommended according to a result of the evaluation.

FIG.1

EP 4 095 625 A1

**Description**

BACKGROUND

1. TECHNICAL FIELD

The present invention relates to a prediction apparatus, a prediction method, a prediction program, and a control apparatus.

2. RELATED ART

Patent Document 1 describes "Control method for uniformizing thickness of oxide film formed on wafer surface in oxidation step of semiconductor manufacturing process by operating temperature distribution in furnace circumferential direction".

[Prior Art Document]

[Patent Document]

[Patent Document 1] Japanese Patent Application Publication No. S61-120427

SUMMARY

In a first aspect of the present invention, a prediction apparatus is provided. The prediction apparatus may include a data acquisition unit configured to acquire setting value data indicating a setting value of a controlled object and physical quantity data indicating a physical quantity of a product obtained by controlling the controlled object. The prediction apparatus may include a prediction unit configured to calculate, using the setting value data and the physical quantity data, a plurality of prediction values obtained by predicting a plurality of physical quantities in the product on a basis of a setting value used for control of the controlled object. The prediction apparatus may include an evaluation unit configured to evaluate the plurality of prediction values on a basis of a predefined reference. The prediction apparatus may include an output unit configured to output a setting value recommended according to a result of the evaluation.
The prediction unit may calculate the plurality of prediction values using a learning model generated by machine-learning a relationship between a setting value of the controlled object and a physical quantity of the product using the setting value data and the physical quantity data as learning data.
The prediction apparatus may further include a learning unit configured to generate the learning model.
The prediction apparatus may further include a feature amount extraction unit configured to extract a change rate of the setting value and a change rate of the physical quantity from the setting value data and the physical quantity data. The learning unit may generate the learning model in which the change rate of the setting value is input and the change rate of the physical quantity is output.
The learning unit may generate the learning model by Gaussian process regression.
The prediction unit may further calculate each of indexes indicating reliabilities of the plurality of prediction values on a basis of a standard deviation obtained by a probability model handled in the machine learning.
The output unit may further output each of the plurality of prediction values together with the index.
The prediction apparatus may further include a setting adjustment unit configured to adjust a setting value in order to search for a setting value at which all of the plurality of prediction values satisfy the predefined reference. The output unit may output the searched setting value as the recommended setting value.
The controlled object may be a heater for adjusting a temperature in a furnace for heat-treating a wafer, and a physical quantity of the product may be a film thickness to be formed on the wafer.
The prediction unit may predict a film thickness to be formed on each of a plurality of wafers disposed in the furnace.
In a second aspect of the present invention, a prediction method is provided. The prediction method may include acquiring setting value data indicating a setting value of a controlled object and physical quantity data indicating a physical quantity of a product obtained by controlling the controlled object. The prediction method may include calculating, using the setting value data and the physical quantity data, a plurality of prediction values obtained by predicting a plurality of physical quantities in the product on a basis of a setting value used for control of the controlled object. The prediction method may include evaluating the plurality of prediction values on a basis of a predefined reference. The prediction method may include outputting a setting value recommended according to a result of the evaluation.
In a third aspect of the present invention, a prediction program is provided. The prediction program may be executed by a computer. The prediction program may cause the computer to function as a data acquisition unit configured to acquire setting value data indicating a setting value of a controlled object and physical quantity data indicating a physical quantity of a product obtained by controlling the controlled object. The prediction program may cause the computer to function as a prediction unit configured to calculate, using the setting value data and the physical quantity data, a plurality of prediction values obtained by predicting a plurality of physical quantities in the product on a basis of a setting value used for control of the controlled object. The prediction program may cause the computer to function as an evaluation unit configured to evaluate the plurality of prediction values on a basis of a predefined reference. The prediction program may cause the computer to function as an output unit configured to output a setting value recommended according to a result of the evaluation.

In a fourth aspect of the present invention, a control apparatus is provided. The control apparatus may include a data acquisition unit configured to acquire setting value data indicating a setting value of a controlled object and physical quantity data indicating a physical quantity of a product obtained by controlling the controlled object. The control apparatus may include a prediction unit configured to calculate, using the setting value data and the physical quantity data, a plurality of prediction values obtained by predicting a plurality of physical quantities in the product on a basis of a setting value used for control of the controlled object. The control apparatus may include an evaluation unit configured to evaluate the plurality of prediction values on a basis of a predefined reference. The control apparatus may include an output unit configured to output a setting value recommended according to a result of the evaluation. The control apparatus may include a control unit configured to control the controlled object according to the recommended setting value.

The summary clause does not necessarily describe all necessary features of the embodiments of the present invention. The present invention may also be a sub-combination of the features described above.

BRIEF DESCRIPTION OF THE DRAWINGS

Fig. 1 illustrates an example of a block diagram of a prediction apparatus 100 according to the present embodiment together with a facility 10 provided with a controlled object 20.

Fig. 2 illustrates an example of a configuration diagram of a diffusion furnace 200 as a specific example of the facility 10.

Fig. 3 illustrates an example of a maintenance flow of the diffusion furnace 200.

Fig. 4 illustrates an example of a flow in which the prediction apparatus 100 according to the present embodiment generates a learning model.

Fig. 5 illustrates an example of an image diagram of Gaussian process regression.

Fig. 6 illustrates an example of a flow in which the prediction apparatus 100 according to the present embodiment predicts a physical quantity.

Fig. 7 illustrates an example of a prediction result by the prediction apparatus 100 according to the present embodiment.

Fig. 8 illustrates an example of output by the prediction apparatus 100 according to the present embodiment.

Fig. 9 illustrates an example of a block diagram of a control apparatus 900 according to the present embodiment together with the facility 10 in which the controlled object 20 is provided.

Fig. 10 illustrates an example of a computer 9900 in which aspects of the present invention may be embodied in whole or in part.

DESCRIPTION OF EXEMPLARY EMBODIMENTS

Hereinafter, the present invention will be described through embodiments of the invention, but the following embodiments do not limit the invention according to the claims. In addition, not all combinations of features described in the embodiments are essential to the solution of the invention.

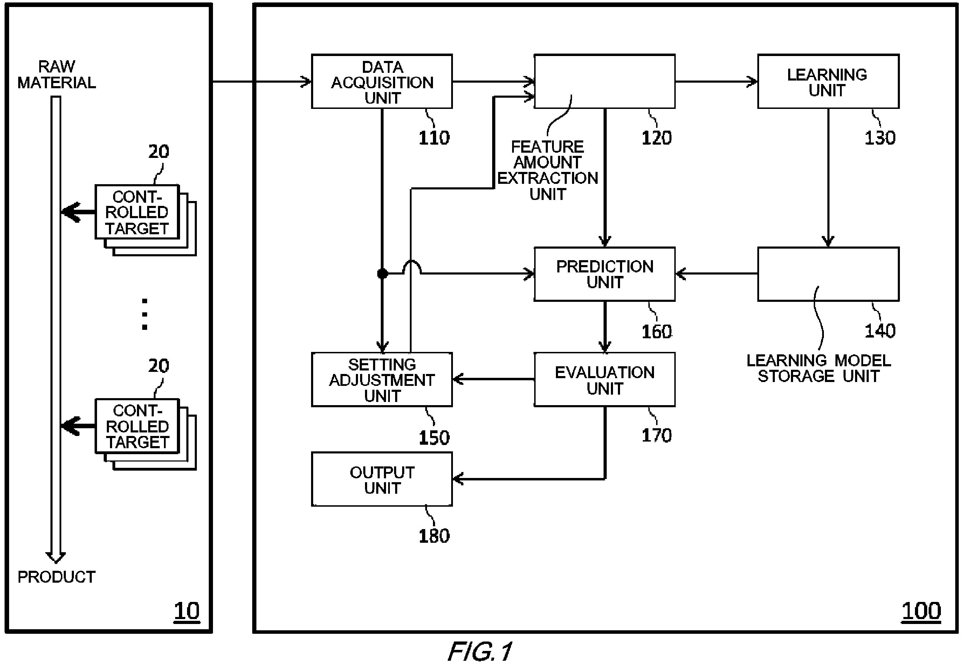

Fig. 1 illustrates an example of a block diagram of a prediction apparatus 100 according to the present embodiment together with a facility 10 provided with a controlled object 20.

The facility 10 is equipment, an apparatus, or the like in which the controlled object 20 is provided. One or more controlled objects 20 may be provided in the facility 10. For example, the facility 10 may be various manufacturing apparatuses used in various manufacturing processes in various industry types such as electronic component, device, and electronic circuit manufacturing industry, metal product manufacturing industry, steel industry, petroleum product and coal product manufacturing industry, chemical industry, fiber industry, wood product manufacturing industry, and food product manufacturing industry. In such a facility 10, raw materials are processed to produce various products. In the present embodiment, a case where the facility 10 is a diffusion furnace used when a film is formed by heat-treating a wafer such as silicon will be described as an example. This will be described later.

The controlled object 20 is a machine to be controlled. For example, the controlled object 20 may be an actuator such as a heater, a valve, a pump, a fan, a motor, and a switch that adjusts at least one physical quantity such as a temperature, a pressure, a pH, a speed, and a flow rate in a manufacturing process of the facility 10. In the present embodiment, a case where the controlled object 20 is a heater for adjusting the temperature (abbreviated as "furnace temperature") in the diffusion furnace will be described as an example.

The prediction apparatus 100 according to the present embodiment predicts a plurality of physical quantities in a product obtained by controlling the controlled object 20 on the basis of the setting values in the manufacturing process executed in such a facility 10. Then, the prediction apparatus 100 according to the present embodiment outputs a recommended setting value according to a result of evaluating a plurality of prediction values obtained by predicting the plurality of physical quantities.

The prediction apparatus 100 may be a computer such as a personal computer (PC), a tablet computer, a smartphone, a workstation, a server computer, or a general purpose computer, or may be a computer system in which a plurality of computers are connected. Such a computer system is also a computer in a broad sense. The prediction apparatus 100 may be implemented by one or more virtual computer environments executable in a computer. Alternatively, the prediction apparatus 100 may be a dedicated computer designed for prediction of a physical quantity, or may be dedicated hardware realized by a dedicated circuit. When the prediction apparatus 100 can be connected to the Internet, the prediction apparatus 100 may be realized by cloud computing.

The prediction apparatus 100 includes a data acquisition unit 110, a feature amount extraction unit 120, a learning unit 130, a learning model storage unit 140, a setting adjustment unit 150, a prediction unit 160, an evaluation unit 170, and an output unit 180. Note that these blocks are functional blocks that are functionally separated from each other, and may not necessarily coincide with an actual device configuration. That is, in the present drawing, even though the block is illustrated as one block, the block may not necessarily be configured by one device. In the present drawing, even if the blocks are illustrated as separate blocks, they may not necessarily be configured by separate devices.

The data acquisition unit 110 acquires setting value data indicating a setting value of the controlled object 20 and physical quantity data indicating a physical quantity of a product obtained by controlling the controlled object 20. For example, the data acquisition unit 110 may acquire such setting value data and physical quantity data from the facility 10 via a network. However, the present invention is not limited thereto. The data acquisition unit 110 may acquire such setting value data and physical quantity data via an operator, or via various memory devices. In the learning phase, the data acquisition unit 110 supplies the acquired setting value data and physical quantity data to the feature amount extraction unit 120. On the other hand, in the prediction phase, the data acquisition unit 110 supplies the acquired setting value data to the feature amount extraction unit 120 and the setting adjustment unit 150, and supplies the acquired physical quantity data to the prediction unit 160.

The feature amount extraction unit 120 extracts a change rate of the setting value and a change rate of the physical quantity from the setting value data and the physical quantity data. For example, in the learning phase, the feature amount extraction unit 120 extracts the change rate of the setting value and the change rate of the physical quantity on the basis of a plurality of setting values indicated by the setting value data and a plurality of physical quantities indicated by the physical quantity data which are supplied from the data acquisition unit 110, respectively. Then, the feature amount extraction unit 120 supplies the extracted change rate of the setting value and the extracted change rate of the physical quantity to the learning unit 130. On the other hand, in the prediction phase, the feature amount extraction unit 120 extracts the change rate of the setting value on the basis of the setting value indicated by the setting value data supplied from the data acquisition unit 110, that is, the setting value actually set to the controlled object 20 in the facility 10 and the setting value after adjustment which has been adjusted by the setting adjustment unit 150 to be described later. Then, the feature amount extraction unit 120 supplies the extracted change rate of the setting value to the prediction unit 160.

The learning unit 130 generates a learning model. For example, in the learning phase, the learning unit 130 generates a learning model in which the change rate of the setting value and the change rate of the physical quantity supplied from the feature amount extraction unit 120 are used as learning data, the change rate of the setting value is input, and the change rate of the physical quantity is output. At this time, the learning unit 130 may generate a learning model by Gaussian process regression. This will be described later. However, the present invention is not limited thereto.

The learning unit 130 may generate the learning model by other various learning algorithms such as linear regression, Elastic Net, a support vector machine, random forest, and a neural network. The learning unit 130 supplies the generated learning model to the learning model storage unit 140.

The learning model storage unit 140 stores the learning model. For example, the learning model storage unit 140 stores the learning model generated by the learning unit 130 in the learning phase. Then, the learning model storage unit 140 supplies the stored learning model to the prediction unit 160 in the prediction phase. Note that, in the above description, the case where the learning model storage unit 140 stores the learning model generated by the learning unit 130 in the prediction apparatus 100 has been described as an example. However, the present invention is not limited thereto. The learning model storage unit 140 may store a learning model generated outside the prediction apparatus 100. That is, the learning unit 130 may be provided outside the prediction apparatus 100 instead of or in addition to the inside of the prediction apparatus 100.

The setting adjustment unit 150 adjusts a setting value to be set in the controlled object 20. In the prediction phase, the setting adjustment unit 150 adjusts the setting value by changing at least one setting value using the setting value data supplied from the data acquisition unit 110 as an initial value. The setting adjustment unit 150 supplies the setting value after adjustment to the feature amount extraction unit 120. In particular, the setting adjustment unit 150 sequentially changes at least one setting value in the setting data supplied from the data acquisition unit 110, thereby adjusting the setting value in order to search for a setting value at which all of a plurality of prediction values described later satisfy a predefined reference.

The prediction unit 160 uses the setting value data and the physical quantity data to calculate a plurality of prediction values obtained by predicting a plurality of physical quantities in the product on the basis of the setting value used for controlling the controlled object 20. For example, in the prediction phase, the prediction unit 160 inputs the change rate of the setting value supplied from the feature amount extraction unit 120 to the learning model supplied from the learning model storage unit 140. Then, the prediction unit 160 predicts a plurality of physical quantities in the product on the basis of the physical quantity data supplied from the data acquisition unit 110 and the change rate of the physical quantity output by the learning model. In this way, the prediction unit 160 may calculate the plurality of prediction values using the learning model generated by machine-learning the relationship between the setting value of the controlled object 20 and the physical quantity of the product using the setting value data and the physical quantity data as the learning data. At this time, the prediction unit 160 may further calculate an index indicating the reliability of the plurality of prediction values on the basis of the standard deviation obtained in the probability model handled in the machine learning. This will be described later. The prediction unit 160 supplies the plurality of calculated prediction values and the index indicating the reliability of the plurality of prediction values to the evaluation unit 170.

The evaluation unit 170 evaluates the plurality of prediction values on the basis of a predefined reference. For example, in the prediction phase, the evaluation unit 170 determines whether the plurality of prediction values supplied from the prediction unit 160 are within a predefined reference range, and evaluates the plurality of prediction values according to the determination result. Then, when the evaluation of the prediction values is completed, the evaluation unit 170 notifies the setting adjustment unit 150 of the completion. In response to this, the setting adjustment unit 150 readjusts the setting value. Then, the feature amount extraction unit 120 extracts a change rate of the setting value on the basis of the readjusted setting value. Then, the prediction unit 160 calculates a plurality of prediction values on the basis of the readjusted setting value. Then, the evaluation unit 170 evaluates the plurality of prediction values based on the readjusted setting value. In this manner, the setting adjustment unit 150 searches for a setting value at which all of the plurality of prediction values satisfy the predefined reference in cooperation with the feature amount extraction unit 120, the prediction unit 160, and the evaluation unit 170. At this time, the evaluation unit 170 stores, as a candidate of the setting value, a setting value at which all of the plurality of prediction values satisfy a predefined reference. Then, when the evaluation is completed for all patterns of the setting value, the evaluation unit 170 supplies at least one setting value among the stored candidates of the setting value to the output unit 180. At this time, the evaluation unit 170 may supply the plurality of prediction values corresponding to the setting value and the index indicating the reliability of the plurality of prediction values together to the output unit 180.

The output unit 180 outputs a recommended setting value according to the evaluated result. For example, in the prediction phase, the output unit 180 outputs the setting value supplied from the evaluation unit 170 as a recommended setting value. That is, the output unit 180 may output, as a recommended setting value, a setting value searched as a setting value at which all of the plurality of prediction values satisfy a predefined reference. At this time, the output unit 180 may further output a plurality of prediction values corresponding to the setting value together with an index indicating the reliability of the plurality of prediction values.

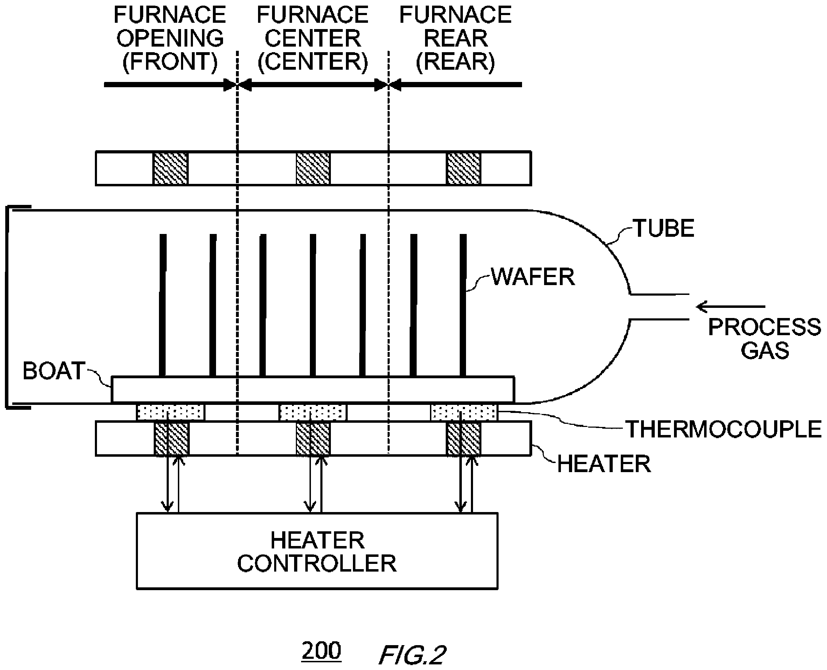

Fig. 2 illustrates an example of a configuration diagram of a diffusion furnace 200 as a specific example of the facility 10. The diffusion furnace 200 is a horizontal heat treatment system used in a film forming process of a wafer as a part of a semiconductor manufacturing process. In such a diffusion furnace 200, the inside of the furnace is heated by a plurality of heaters provided in the vicinity of the tube. A plurality of wafers (seven wafers in this drawing) are evenly disposed on a boat in the furnace surrounded by the tube. Process gas (for example, oxygen gas or the like) is injected from the furnace rear. As a result, the wafer surface is oxidized to form an oxide film. In this drawing, as an example, a case is illustrated in which the furnace temperature is adjusted by feedback-controlling three heaters provided for the furnace opening (front), the furnace center (center), and the furnace rear (rear) such that the measurement value indicated by the corresponding thermocouple becomes the setting value set for each heater.

In such a diffusion furnace 200, in order to uniformly control the film thickness formed on each of the plurality of wafers, for example, it is necessary to adjust four parameters of a furnace opening temperature Tf, a furnace center temperature Tc, a furnace rear temperature Tr, and a film formation time t as furnace temperature settings. Such furnace temperature settings need to be adjusted not only in the film forming process of actually forming a wafer but also in periodic maintenance of the diffusion furnace 200.

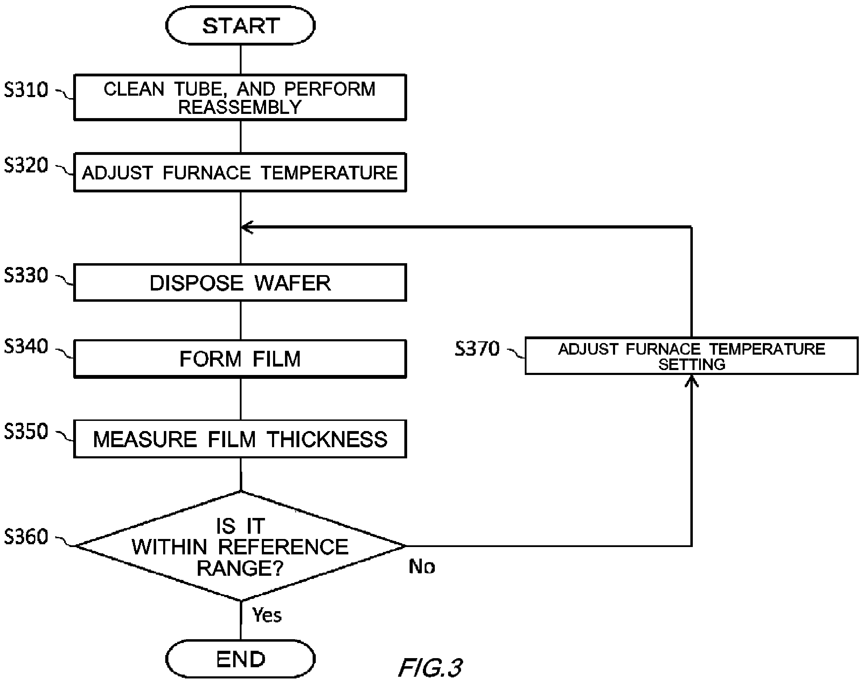

Fig. 3 illustrates an example of a maintenance flow of the diffusion furnace 200. In Step S310, cleaning of the tube and reassembly of the diffusion furnace 200 are performed. For example, the operator removes the thermocouple or the like from the tube and cleans the tube. Then, the operator reassembles the configuration of the thermocouple after cleaning the tube.

In Step S320, the furnace temperature is adjusted. For example, the operator sets the furnace opening temperature Tf, the furnace center temperature Tc, and the furnace rear temperature Tr for three heaters provided for the furnace opening, the furnace center, and the furnace rear, respectively, and adjusts the furnace temperature so that the temperature of the entire furnace becomes flat.

In Step S330, the wafer is disposed. For example, the operator evenly disposes the plurality of wafers on the boat in the tube from the furnace rear to the furnace opening.

In Step S340, film formation is performed. For example, the operator injects the process gas from the furnace rear and causes the plurality of wafers to stand by in the furnace for the set film formation time t, thereby forming the oxide film on the surfaces of the plurality of wafers.

In Step S350, film thickness measurement is performed. For example, the operator takes out all the wafers from the furnace after the film formation time t has elapsed. Then, the operator measures each of the film thicknesses of the oxide films formed on all the wafers taken out.

In Step S360, it is determined whether the film thickness is within the reference range. For example, the operator determines whether all of the film thicknesses measured in Step S350 are within a predefined reference range. When it is determined in Step S360 that all of the film thicknesses are within the reference range (Yes), the operator ends the maintenance flow. On the other hand, when it is determined in Step S360 that not all of the film thicknesses are within the reference range (No), the operator advances the process to Step S370.

In Step S370, furnace temperature setting adjustment is performed. For example, the operator adjusts a furnace temperature setting based on the film thickness measured in Step S350. Then, the operator returns the process to Step S330 to continue the maintenance flow. That is, the operator repeats the process from Step S330 to Step S370 until all the film thicknesses are within the reference range in Step S360.

At this time, the adjustment amount of the furnace temperature setting for causing the film thickness formed on all the wafers to be within the reference range has been determined by the past experience and intuition of the operator. In this case, if some setting values are changed so that the film thicknesses formed on some wafers are within the reference range, the film thickness formed on another wafer falls outside the reference range due to the change, and thus, there has occurred an unnecessary process of readjusting the furnace temperature setting by trial and error many times. In the furnace temperature setting, as described above, there are a plurality of parameters such as the furnace opening temperature Tf, the furnace center temperature Tc, the furnace rear temperature Tr, and the film formation time t, and it has been difficult for the operator to determine which parameters should be adjusted to what extent in consideration of the current film thickness measurement value to cause the film thicknesses formed on all the wafers to fall within the reference range.

Therefore, as an example, the prediction apparatus 100 according to the present embodiment supports such a furnace temperature setting adjustment work of the diffusion furnace 200. That is, as an example, the prediction apparatus 100 according to the present embodiment predicts the film thickness of each of the plurality of wafers to be formed when the furnace temperature is controlled on the basis of the setting value in the film forming process executed in the diffusion furnace 200. Then, the prediction apparatus 100 outputs a recommended furnace temperature setting according to a result of evaluating the predicted film thickness for each of the plurality of wafers.

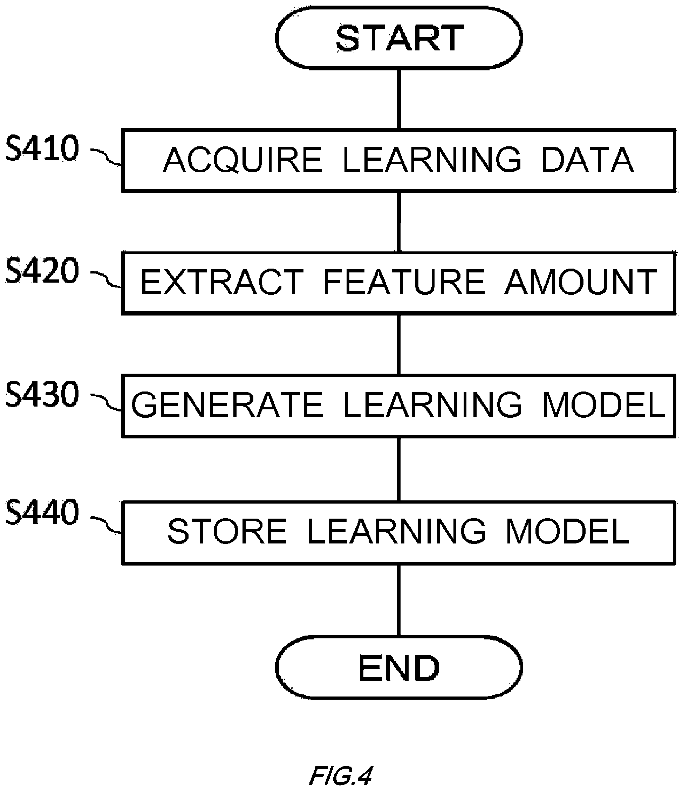

Fig. 4 illustrates an example of a flow in which the prediction apparatus 100 according to the present embodiment generates a learning model. The prediction apparatus 100 according to the present embodiment generates a learning model by this flow, for example. Note that, as described above, when the prediction apparatus 100 uses a learning model generated outside, this flow may be omitted.

In Step S410, the prediction apparatus 100 acquires learning data. For example, the data acquisition unit 110 acquires setting value data indicating a setting value of the controlled object 20 and physical quantity data indicating a physical quantity of a product obtained by controlling the controlled object 20 from the facility 10 via the network. As an example, every time maintenance of the diffusion furnace 200 is performed, the data acquisition unit 110 acquires the setting value data indicating the furnace temperature setting and the physical quantity data indicating the measurement values of the film thicknesses formed on the plurality of wafers.

Here, as described above, the furnace temperature setting may include the furnace opening temperature $Tf$, the furnace center temperature $Tc$, the furnace rear temperature $Tr$, and the film formation time $t$. The film thickness may include, for example, film thicknesses $Wa$ to $Wg$ formed on the wafers disposed at seven positions a to g in the furnace. That is, the data acquisition unit 110 may acquire, as the setting value data at the time of the first maintenance, a furnace opening temperature $Tf1$, a furnace center temperature $Tc1$, a furnace rear temperature $Tr1$, and a film formation time $t1$ set at the time of the first maintenance. The data acquisition unit 110 may acquire, as the physical quantity data at the time of the first maintenance, film thicknesses $Wa1$ to $Wg1$ formed on the wafers disposed at the positions a to g measured at the time of at the first maintenance. Similarly, the data acquisition unit 110 may acquire, as setting value data at the time of the second maintenance, a furnace opening temperature $Tf2$, a furnace center temperature $Tc2$, a furnace rear temperature $Tr2$, and a film formation time $t2$ set at the time of the second maintenance. The data acquisition unit 110 may acquire, as the physical quantity data at the time of the second maintenance, film thicknesses $Wa2$ to $Wg2$ formed on the wafers disposed at the positions a to g measured at the time of the second maintenance. The data acquisition unit 110 supplies the setting value data and the physical quantity data acquired in this manner at the time of maintenance a plurality of times to the feature amount extraction unit 120.

In Step S420, the prediction apparatus 100 extracts a feature amount. For example, the feature amount extraction unit 120 extracts a change rate of the setting value and a change rate of the physical quantity from the setting value data and the physical quantity data. As an example, the feature amount extraction unit 120 extracts a furnace temperature setting change rate and a film thickness change rate using the setting value data and the physical quantity data acquired at the time of maintenance a plurality of times in Step S410. For example, the feature amount extraction unit 120 calculates a "furnace opening temperature change rate $RTf21$" by dividing the "furnace opening temperature $Tf2$" set at the time of the second maintenance by the "furnace opening temperature $Tf1$" set at the time of the first maintenance. Similarly, the feature amount extraction unit 120 calculates a "furnace center temperature change rate $RTc21$" by dividing the "furnace center temperature $Tc2$" set at the time of the second maintenance by the "furnace center temperature $Tc1$" set at the time of the first maintenance. Similarly, the feature amount extraction unit 120 calculates a "furnace rear temperature change rate $RTr21$" by dividing the "furnace rear temperature $Tr2$" set at the time of the second maintenance by the "furnace rear temperature $Tr1$" set at the time of the first maintenance. Similarly, the feature amount extraction unit 120 calculates a "film formation time change rate $Rt21$" by dividing the "film formation time $t2$" set at the time of the second maintenance by the "film formation time $t1$" set at the time of the first maintenance. The feature amount extraction unit 120 extracts the furnace opening temperature change rate $RTf21$, the furnace center temperature change rate $RTc21$, the furnace rear temperature change rate $RTr21$, and the film formation time change rate $Rt21$ calculated in this manner as the furnace temperature setting change rate $RT21$ between the second and first maintenances. The feature amount extraction unit 120 extracts a furnace temperature setting change rate $RT31$ between the third and first maintenances and a furnace temperature setting change rate $RT41$ between the fourth and first maintenances by executing similar processing. In this manner, the feature amount extraction unit 120 extracts the furnace temperature setting change rate $RT$ between the plurality of maintenances as the change rate of the setting value.

In addition, the feature amount extraction unit 120 calculates a "film thickness change rate $RWa21$" for the position a by dividing the "film thickness $Wa2$" formed on the wafer disposed at the position a measured at the time of the second maintenance by the "film thickness $Wa1$" formed on the wafer disposed at the position a measured at the time of the first maintenance. The feature amount extraction unit 120 executes similar processing to calculate a "film thickness change rate $RWb21$", a "film thickness change rate $RWc21$", a "film thickness change rate $RWd21$", a "film thickness change rate $RWe21$", a "film thickness change rate $RWf21$", and a "film thickness change rate $RWg21$" for the positions b to g. The feature amount extraction unit 120 extracts the "film thickness change rate $RWa21$", the "film thickness change rate $RWb21$", the "film thickness change rate $RWc21$", the "film thickness change rate $RWd21$", the "film thickness change rate $RWe21$", the "film thickness change rate $RWf21$", and the "film thickness change rate $RWg21$" calculated in this manner as a film thickness change rate $RW21$ between the second and first maintenances. The feature amount extraction unit 120 extracts a film thickness change rate $RW31$ between the third and first maintenances and a film thickness change rate $RW41$ between the fourth and first maintenances by executing similar processing. In this manner, the feature amount extraction unit 120 extracts the film thickness change rates $RW$ between the plurality of maintenances as the change rate of the physical quantity. The feature amount extraction unit 120 supplies the extracted change rate of the setting value and the change rate of the physical quantity to the learning unit 130.

In Step S430, the prediction apparatus 100 generates a learning model. For example, the learning unit 130 generates a learning model. As an example, the learning unit 130 generates a learning model in which the change rate of the setting value and the change rate of the physical quantity extracted in Step S420 are used as learning data, the change rate of the setting value is input, and the change rate of the physical quantity is output. That is, in the present embodiment, the learning unit 130 generates a learning model in which the furnace temperature setting change rate $RT$ is input and the film thickness change rate $RW$ is output. That is, the learning unit 130 generates, by learning, a model that predicts how much the film thickness to be formed on the wafer disposed at which position changes when which parameter of the furnace temperature setting is changed to what extent. The learning unit 130 supplies the generated learning model to the learning model storage unit 140.

In Step S440, the prediction apparatus 100 stores the learning model. For example, the learning model storage unit 140 stores the learning model. As an example, the learning model storage unit 140 stores the learning model generated in Step S430. In this way, the prediction apparatus 100 according to the present embodiment ends the flow of generating the learning model.

Note that, in generating the learning model, the learning unit 130 may generate the learning model by Gaussian process regression. Here, the Gaussian process regression is one of models for estimating a function y = f(x) from an input variable x to a real value y as an output variable. One of the features of Gaussian process regression is its nonlinearity, which is particularly effective when linear regression cannot fit well. Another feature of the Gaussian process regression is that Bayesian estimation is used. The function estimated in the Gaussian process regression is obtained not as one function but as a distribution of functions. As a result, it is possible to express the uncertainty of the estimation by using the Gaussian process regression. This will be described in detail.

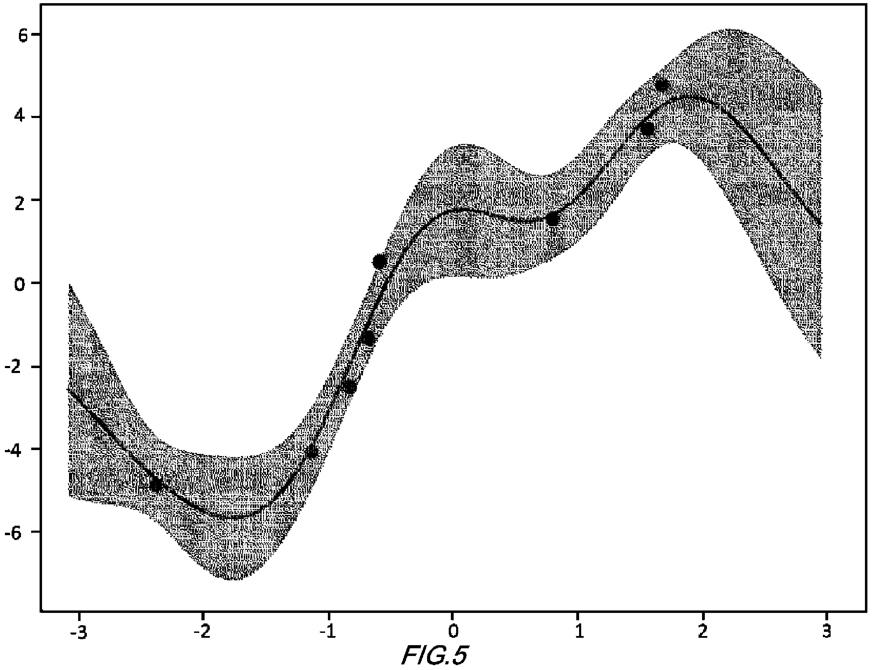

Fig. 5 illustrates an example of an image diagram of Gaussian process regression. The prediction apparatus 100 according to the present embodiment may generate a learning model by, for example, Gaussian process regression by executing the flow of Fig. 4. As described above, such Gaussian process regression is one of models for estimating a function y = f(x) from an input variable x to a real value y as an output variable, and the function f(x) is expressed by the following expression. Here, N represents a normal distribution, $\mu$ represents an average, and $\sigma$ represents a standard deviation. That is, it means that the function f(x) estimated in the Gaussian process regression follows the normal distribution N indicated by the average $\mu$ and the variance $\sigma^2$.

$$f(x) = N(\mu, \sigma^2)$$

In the drawing, the horizontal axis represents the input variable x, and the vertical axis represents the real value y. In the drawing, dots indicate data points. In this drawing, a curve drawn by a solid line indicates the average $\mu$ in the above expression. In addition, in this drawing, a belt-shaped region covering the upper and lower sides of the curve indicates the standard deviation $\sigma$ in the above expression. The width in the vertical axis direction in such a belt-shaped region means the uncertainty of the function. That is, in the drawing, a portion having a small width in the vertical axis direction in the belt-shaped region has high prediction reliability, and a portion having a large width in the vertical axis direction has low prediction reliability. Since the prediction apparatus 100 according to the present embodiment calculates the plurality of prediction values using the learning model generated by such Gaussian process regression, it is possible to calculate indexes indicating reliability of the plurality of prediction values together.

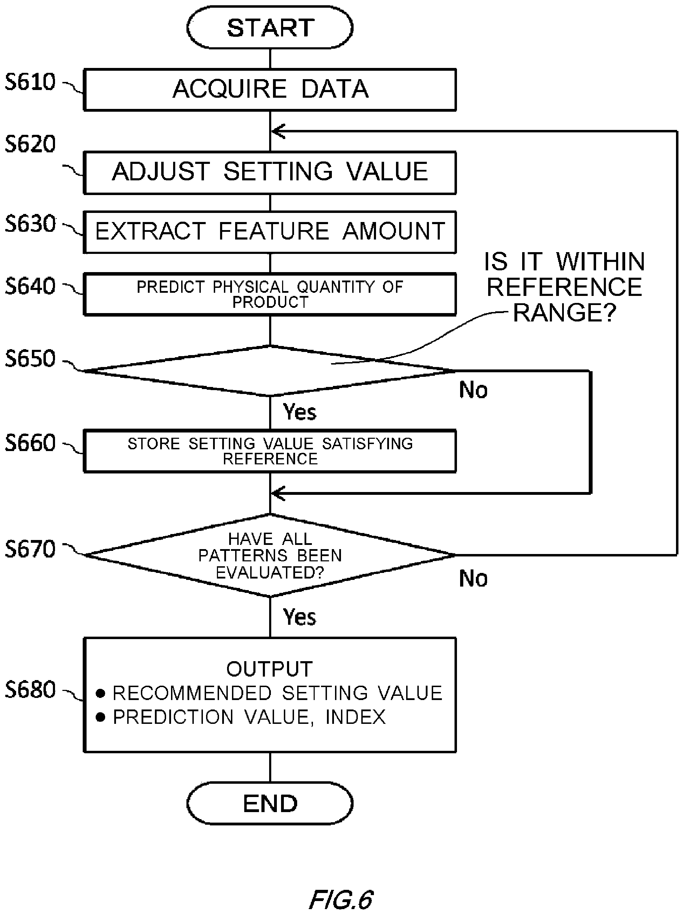

Fig. 6 illustrates an example of a flow in which the prediction apparatus 100 according to the present embodiment predicts a physical quantity. In this flow, a case where the controlled object 20 is a heater for adjusting the temperature in the diffusion furnace for heat-treating the wafer as described above, and the physical quantity of the product is the film thickness to be formed on the wafer will be described as an example.

In Step S610, the prediction apparatus 100 acquires data necessary for prediction. For example, the data acquisition unit 110 acquires setting value data indicating a setting value of the controlled object 20 and physical quantity data indicating a physical quantity of a product obtained by controlling the controlled object 20 from the facility 10 via the network. As an example, the data acquisition unit 110 acquires setting value data indicating furnace temperature setting at the time of the current maintenance and measurement value data indicating measurement values of film thicknesses formed on a plurality of wafers.

Here, the data acquisition unit 110 may acquire, for example, the furnace opening temperature Tf, the furnace center temperature Tc, the furnace rear temperature Tr, and the film formation time t set at the time of the current maintenance as the setting value data T at the time of the current maintenance. In addition, the data acquisition unit 110 may acquire the film thicknesses Wa to Wg formed on the wafers disposed at the positions a to g measured at the time of the current maintenance as the physical quantity data W at the time of the current maintenance. Note that at least one of the film thicknesses Wa to Wg acquired here is assumed to be out of a predefined reference range. The data acquisition unit 110 supplies the setting value data T acquired in this manner to the feature amount extraction unit 120 and the setting adjustment unit 150. The data acquisition unit 110 supplies the physical quantity data W acquired in this manner to the prediction unit 160.

In Step S620, the prediction apparatus 100 adjusts the setting value. For example, the setting adjustment unit 150 adjusts the setting value by changing at least one setting value using the setting value data T acquired in Step S610 as an initial value. As an example, the setting adjustment unit 150 adjusts the setting value T by raising/lowering the furnace temperature of at least one of the furnace opening temperature Tf, the furnace center temperature Tc, and the furnace rear temperature Tr set at the time of the current maintenance by one degree, or by increasing/shortening the film formation time t by one second. The setting adjustment unit 150 supplies a setting value T' after adjustment to the feature amount extraction unit 120.

In Step S630, the prediction apparatus 100 extracts a feature amount. For example, the feature amount extraction unit 120 extracts a change rate (adjustment rate) of the setting value from the setting value data T. As an example, the feature amount extraction unit 120 extracts a change rate of the setting value based on the setting value data T acquired in Step S610 and the setting value T' after adjustment which has been adjusted in Step S620. For example, the feature amount extraction unit 120 calculates a "furnace opening temperature adjustment rate RTf" by dividing a "furnace opening temperature Tf" after adjustment by the "furnace opening temperature Tf' before adjustment. Similarly, the feature amount extraction unit 120 calculates a "furnace center temperature adjustment rate RTc" by dividing a "furnace center temperature Tc'" after adjustment by the "furnace center temperature Tc" before adjustment. Similarly, the feature amount extraction unit 120 calculates a "furnace rear temperature adjustment rate RTr" by dividing a "furnace rear temperature Tr'" after adjustment by the "furnace rear temperature Tr" before adjustment. Similarly, the feature amount extraction unit 120 calculates a "film formation time adjustment rate Rt" by dividing a "film formation time t'" after adjustment by the "film formation time t" before adjustment. The feature amount extraction unit 120 extracts the furnace opening temperature adjustment rate RTf, the furnace center temperature adjustment rate RTc, the furnace rear temperature adjustment rate RTr, and the film formation time adjustment rate Rt calculated in this manner as the change rates of the setting values. The feature amount extraction unit 120 supplies the change rates of the extracted setting values to the prediction unit 160.

In Step S640, the prediction apparatus 100 predicts the physical quantity of the product. For example, the prediction unit 160 uses the setting value data and the physical quantity data to calculate a plurality of prediction values obtained by predicting a plurality of physical quantities in the product on the basis of the setting value used for controlling the controlled object 20. As an example, the prediction unit 160 reads the learning model from the learning model storage unit 140. Then, the prediction unit 160 inputs the change rate of the setting value extracted in Step S630 to the learning model. As a result, the learning model outputs the change rate of the physical quantity according to the change rate of the setting value. That is, the learning model outputs film thickness change rates RWa to RWg indicating how much the film thickness to be formed on each of the wafers disposed at the positions a to g changes when the furnace temperature setting is changed in accordance with the furnace opening temperature adjustment rate RTf, the furnace center temperature adjustment rate RTc, the furnace rear temperature adjustment rate RTr, and the film formation time adjustment rate Rt. Then, the prediction unit 160 multiplies each of the film thickness change rates RWa to RWg by the film thicknesses Wa to Wg acquired in Step S610 as initial values, thereby calculating a plurality of prediction values Wa' to Wg' predicting the film thicknesses that will be formed on the wafers disposed at the positions a to g when the controlled object 20 is controlled by the furnace temperature setting after adjustment. That is, the prediction unit 160 predicts each film thickness to be formed on each of the plurality of wafers disposed in the furnace. In this way, the prediction unit 160 may calculate the plurality of prediction values using the learning model generated by machine-learning the relationship between the setting value of the controlled object 20 and the physical quantity of the product using the setting value data and the physical quantity data as the learning data.

The prediction unit 160 may further calculate an index indicating the reliability of the plurality of prediction values Wa' to Wg' on the basis of the standard deviation obtained in the probability model handled in the machine learning. Here, as described above, the learning model may be generated by Gaussian process regression. Therefore, the prediction unit 160 can calculate each of indexes indicating the reliabilities of the plurality of prediction values Wa' to Wg' on the basis of the standard deviation of the Gaussian distribution according to such a Gaussian process regression. Here, for example, the prediction unit 160 may calculate, as an index indicating the reliability of each of the plurality of prediction values Wa' to Wg', a value obtained by multiplying each of standard deviations $\sigma$ corresponding to the plurality of film thickness change rates RWa to RWg output by the learning model by 1.96. Note that this is because a 95% confidence interval is generally indicated by the average $\mu \pm 1.96\sigma$. The prediction unit 160 supplies a plurality of calculated prediction values Wan' to Wgn' and the indexes indicating the reliabilities of the plurality of prediction values Wa' to Wg' to the evaluation unit 170.

In Step S650, the prediction apparatus 100 determines whether the plurality of prediction values are within the reference range. For example, the evaluation unit 170 determines whether all of the plurality of prediction values Wa' to Wg' predicted in Step S640 are within a predefined reference range. In this manner, the evaluation unit 170 evaluates the plurality of prediction values on the basis of a predefined reference. When it is determined in Step S650 that all of the plurality of prediction values Wa' to Wg' are within the reference range (Yes), the prediction apparatus 100 advances the process to Step S660.

In Step S660, the prediction apparatus 100 stores a setting value that satisfies the reference. For example, the evaluation unit 170 stores, as candidates of the setting value, the furnace opening temperature Tf', the furnace center temperature Tc', the furnace rear temperature Tr', and the film formation time t' after adjustment in which all of the plurality of prediction values Wa' to Wg' are determined to be within the reference range in Step S650. At this time, the evaluation unit 170 may store the plurality of prediction values Wa' to Wg' and the indexes indicating the reliabilities of the plurality of prediction values Wa' to Wg' together. Then, the evaluation unit 170 notifies the setting adjustment unit 150 that the evaluation of the prediction value has ended.

On the other hand, when it is determined in Step S650 that at least one of the plurality of prediction values Wa' to Wg' is out of the reference range (No), the prediction apparatus 100 advances the process to Step 670. That is, when it is determined in Step S650 that at least one of the plurality of prediction values Wa' to Wg' is out of the reference range, the evaluation unit 170 notifies the setting adjustment unit 150 that the evaluation of the prediction value has ended without storing the setting value T' corresponding to the plurality of prediction values Wa' to Wg'.

In Step S670, the prediction apparatus 100 determines whether all patterns have been evaluated. For example, the setting adjustment unit 150 adjusts the setting value for all adjustable patterns by raising/lowering the furnace temperature of at least one of the furnace opening temperature Tf, the furnace center temperature Tc, and the furnace rear temperature Tr by one degree, or by further increasing/shortening the film formation time t by one second. Then, the setting adjustment unit 150 determines whether the evaluation of all patterns of the setting value T' after adjustment has been completed according to whether it has been notified from the evaluation unit 170 that the evaluation of the prediction value has been completed for all patterns.

In a case where it is determined in Step S670 that the evaluation of all patterns has not been completed (No), the prediction apparatus 100 returns the process to Step S620 and repeats the process from Step S620 to Step S670. In response to this, the setting adjustment unit 150 readjusts the setting value. Then, the feature amount extraction unit 120 extracts a change rate of the setting value on the basis of the readjusted setting value. Then, the prediction unit 160 calculates a plurality of prediction values on the basis of the readjusted setting value. Then, the evaluation unit 170 evaluates the plurality of prediction values based on the readjusted setting value. In this manner, the setting adjustment unit 150 searches for a setting value at which all of the plurality of prediction values satisfy the predefined reference in cooperation with the feature amount extraction unit 120, the prediction unit 160, and the evaluation unit 170.

On the other hand, when it is determined in Step S670 that all patterns have been evaluated (Yes), the prediction apparatus 100 advances the process to Step S680.

In Step S680, the prediction apparatus 100 outputs a recommended setting value. For example, the output unit 180 outputs the recommended setting value according to the evaluated result. As an example, the evaluation unit 170 supplies at least one of the setting value candidates stored in Step 660 to the output unit 180. At this time, the evaluation unit 170 may supply the corresponding plurality of prediction values Wa' to Wg' and the indexes indicating the reliabilities of the plurality of prediction values Wa' to Wg' together to the output unit 180. Then, the output unit 180 outputs the setting value supplied from the evaluation unit 170 as a recommended setting value. That is, the output unit 180 may output, as a recommended setting value, a setting value searched as a setting value at which all of the plurality of prediction values satisfy a predefined reference. At this time, the output unit 180 may further output a plurality of prediction values corresponding to the recommended setting value together with indexes indicating the reliabilities of the plurality of prediction values.

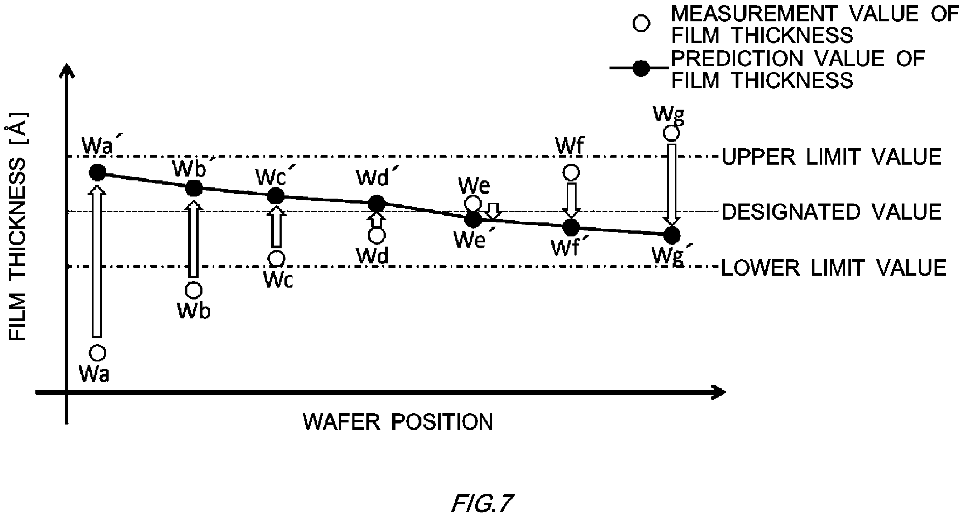

Fig. 7 illustrates an example of a prediction result by the prediction apparatus 100 according to the present embodiment. In the drawing, the horizontal axis represents the wafer position, the left side represents the furnace opening, and the right side represents the furnace rear. In this drawing, the vertical axis represents the film thickness formed on the wafer disposed at each position. In this drawing, the data points of white circles indicate the actual measurement values of the film thicknesses obtained by actually measuring the film thicknesses formed on the wafers disposed at the respective positions, that is, the film thicknesses Wa to Wg. In addition, in this drawing, the data points of black circles indicate the prediction values of the film thicknesses to be formed on the wafers disposed at the respective positions, that is, the plurality of prediction values Wa' to Wg'.

As indicated by the white circles in this drawing, it can be seen that the actual measurement values of the film thicknesses formed on the wafers disposed near the furnace opening (positions a and b) fall below a lower limit value. Therefore, when the furnace temperature setting is adjusted from the setting value T to the setting value T', the prediction apparatus 100 according to the present embodiment predicts the change rates of the film thicknesses that will be formed on the wafers disposed at the respective positions. That is, the prediction apparatus 100 predicts how much the data indicated by the white circles in this drawing changes when the setting value is adjusted from the setting value T to the setting value T'. As a result, the prediction apparatus 100 according to the present embodiment can predict the prediction values Wa' to Wg' of the film thicknesses that will be formed on the wafers disposed at the respective positions as indicated by the black circles in the drawing.

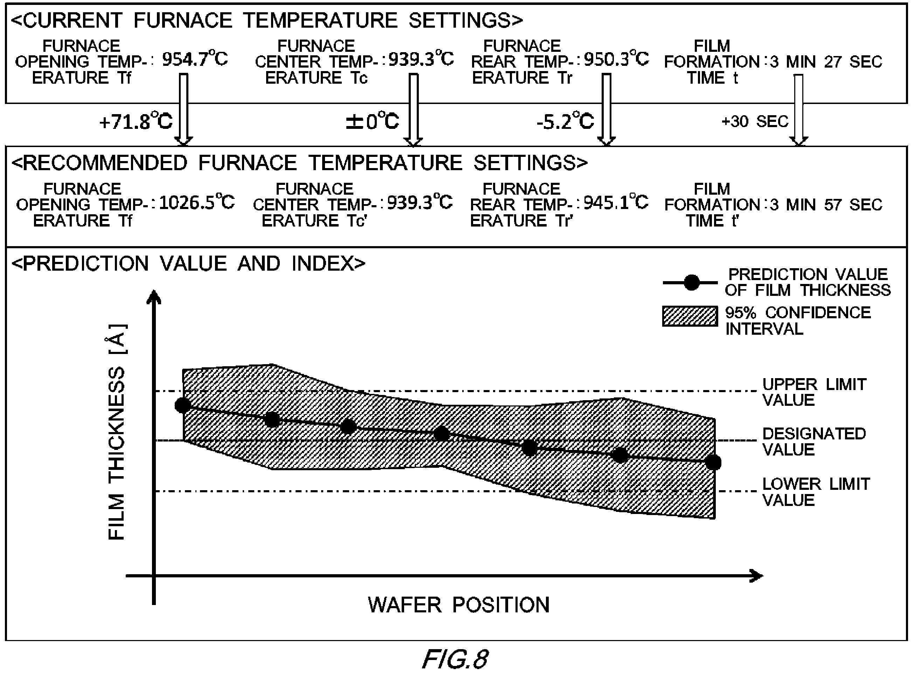

Fig. 8 illustrates an example of output by the prediction apparatus 100 according to the present embodiment. It is assumed that, as the furnace temperature setting at the time of the current maintenance, the furnace opening temperature Tf = 954.7 degrees, the furnace center temperature Tc = 939.3 degrees, the furnace rear temperature Tr = 950.3 degrees, and the film formation time t = 3 minutes 27 seconds are set. As a result of controlling the heater on the basis of such furnace temperature setting, as indicated by the white circles in Fig. 7, a result has been obtained in which the actual measurement values of the film thicknesses formed on the wafers disposed near the furnace opening fall below the lower limit value. Therefore, the prediction apparatus 100 according to the present embodiment predicts a plurality of prediction values when the setting value is adjusted according to the flow of Fig. 6, and outputs a recommended setting value. In the drawing, a case is illustrated in which the prediction apparatus 100 outputs the furnace opening temperature Tf' = 1026.5 degrees, the furnace center temperature Tc' = 939.3 degrees, the furnace rear temperature = 945.1 degrees, and the film formation time t' = 3 minutes 57 seconds as recommended furnace temperature settings. At this time, the prediction apparatus 100 can further output a plurality of prediction values obtained by predicting the film thicknesses that will be formed on the wafers disposed at the respective positions when the heater is controlled on the basis of the recommended furnace temperature settings, as indicated by the black circles in the drawing. The prediction apparatus 100 can also output the indexes (95% confidence interval) corresponding to the plurality of prediction values as indicated by the hatched portion in the drawing.

Conventionally, for example, as indicated by the white circles in Fig. 7, when the actual measurement value of the film thickness formed on a wafer disposed near the furnace opening falls below the lower limit value, it is conceivable to increase the setting value of the furnace opening temperature. However, the increase in the furnace opening temperature can affect not only the film thickness of the wafer in the vicinity of the furnace opening but also the film thickness of the wafer disposed in the vicinity of the furnace center (for example, the position c, the position d, and the position e) or in the vicinity of the furnace rear (for example, the position f and the position g). Therefore, it is difficult to determine which parameter should be adjusted to what extent in order to set the film thicknesses formed on the wafers disposed at all positions within the reference range. As a result, the operator needs to readjust the furnace temperature setting by trial and error many times.

On the other hand, the prediction apparatus 100 according to the present embodiment predicts a plurality of physical quantities in the product obtained by controlling the controlled object 20 on the basis of the setting value. Then, the prediction apparatus 100 according to the present embodiment outputs a recommended setting value according to a result of evaluating a plurality of prediction values obtained by predicting the plurality of physical quantities. As a result, according to the prediction apparatus 100 according to the present embodiment, it is possible to suppress the load of adjusting the setting value by the operator. For example, when the controlled object 20 is a heater for adjusting the temperature in the furnace for heat-treating the wafer, and the physical quantity of the product is the film thickness to be formed on the wafer, the prediction apparatus 100 according to the present embodiment can predict the film thickness to be formed on each of the plurality of wafers disposed in the diffusion furnace 200. As a result, according to the prediction apparatus 100 of the present embodiment, the maintenance time of the diffusion furnace 200 can be greatly shortened, and accordingly the operation rate of the semiconductor manufacturing process by the diffusion furnace 200 can be improved.

The prediction apparatus 100 according to the present embodiment calculates a plurality of prediction values using a learning model generated by machine-learning the relationship between the setting value of the controlled object 20 and the physical quantity of the product using the setting value data and the physical quantity data as learning data. As a result, the prediction apparatus 100 according to the present embodiment can calculate a plurality of prediction values on the basis of objective grounds.

The prediction apparatus 100 according to the present embodiment generates such a learning model by machine learning. As a result, the prediction apparatus 100 according to the present embodiment can realize the learning function and the prediction function by an integrated device.

At this time, the prediction apparatus 100 according to the present embodiment generates a learning model in which the change rate of the setting value is input and the change rate of the physical quantity is output. As a result, the prediction apparatus 100 according to the present embodiment can learn the relative relationship between the setting value and the physical quantity.

The prediction apparatus 100 according to the present embodiment generates a learning model by Gaussian process regression. As a result, the prediction apparatus 100 according to the present embodiment can calculate each of the indexes indicating the reliabilities of the plurality of prediction values on the basis of the standard deviation obtained in the probability model handled by the machine learning, such as the standard deviation of the Gaussian distribution according to the Gaussian process regression.

In addition to the recommended setting value, the prediction apparatus 100 according to the present embodiment outputs the plurality of prediction values when the controlled object 20 is controlled according to the setting value and the indexes indicating the reliabilities of the plurality of prediction values. As a result, according to the prediction apparatus 100 of the present embodiment, as a result of controlling the controlled object 20 according to the recommended setting value, it is possible to let the operator know how many physical quantities of the product are predicted to be obtained and how likely the prediction is. Therefore, for example, as the learning data increases and the prediction accuracy of the learning model increases, the reliability of the prediction value is displayed to increase, so that the operator can perform the work while confirming how much the prediction accuracy of the learning model is improved.

The prediction apparatus 100 according to the present embodiment searches for a setting value at which all of the plurality of prediction values satisfy a predefined reference, and outputs the searched setting value as a recommended setting value. As a result, the prediction apparatus 100 according to the present embodiment can substitute for conventional trial and error performed by an operator.

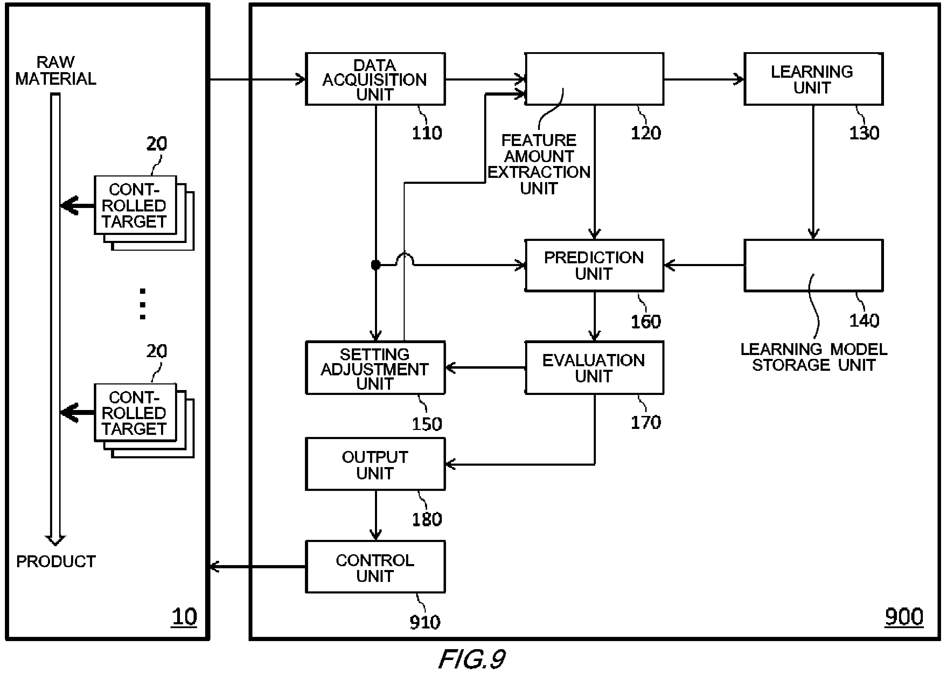

Fig. 9 illustrates an example of a block diagram of the control apparatus 900 according to the present embodiment together with the facility 10 provided with the controlled object 20. In Fig. 9, members having the same functions and configurations as those in Fig. 1 are denoted by the same reference numerals, and description thereof will be omitted except for differences. In addition to the prediction apparatus 100 described above, the control apparatus 900 according to the present embodiment further has a function of controlling the controlled object 20 according to a recommended setting value. That is, a control apparatus 900 according to the present embodiment provides the controlled object 20 with a manipulated variable (MV) based on the recommended setting value. The control apparatus 900 according to the present embodiment further includes a control unit 910 in addition to the functional units included in the prediction apparatus 100 described above.

The control unit 910 controls the controlled object 20 according to the recommended setting value. For example, when the furnace opening temperature Tf = 1026.5 degrees, the furnace center temperature Tc' = 939.3 degrees, the furnace rear temperature = 945.1 degrees, and the film formation time t' = 3 minutes 57 seconds are output as recommended setting values, the control unit 910 feedback-controls the three heaters in the diffusion furnace 200 according to the setting values. As a result, the control apparatus 900 according to the present embodiment can actually control the controlled object 20 according to the recommended setting value, and the prediction function and the control function can be realized as an integrated apparatus. Note that the functional units provided the prediction apparatus 100 in the control apparatus 900 may be partially realized by an external apparatus (for example, when the control apparatus 900 is connectable to the Internet, cloud computing is performed). That is, a generation function (for example, the learning unit 130) of a learning model may be realized by cloud computing, and the control apparatus 900 may download the learning model generated in the cloud, predict and evaluate the physical quantity using the downloaded learning model, and control the controlled object 20 according to the setting value according to the evaluation result. Further, a prediction function and an evaluation function (for example, the feature amount extraction unit 120 to the output unit 180) of a physical quantity may also be realized by cloud computing, and the control apparatus 900 may acquire a recommended setting value output from the cloud and control the controlled object 20 according to the acquired recommended setting value.

Note that the above-described embodiments may be modified or applied in various forms. For example, when data such as a positional deviation of the thermocouple installed in the diffusion furnace 200 before and after maintenance and a flow rate change amount of the process gas can be acquired, the prediction apparatus 100 may also add a change rate in such data as the change rate of the setting value.

In the above description, the case where the prediction technique according to the present embodiment is applied at the time of maintenance in the diffusion furnace 200 has been described as an example, but the prediction technique according to the present embodiment may also be applied at the time of manufacturing process. In general, in the manufacturing process, a film forming work is performed using a furnace temperature setting adjusted at the time of maintenance. However, as particles and the like are accumulated in the tube during manufacturing, the growth degree of the film thickness with respect to the adjusted furnace temperature setting becomes weak, and the possibility that the film thickness falls below a predefined reference range gradually increases. In particular, immediately before the periodic maintenance is performed, the possibility that the film thickness falls below the lower limit value of the reference range becomes higher, and a phenomenon that the yield rate of the product decreases occurs.

Therefore, the prediction technique according to the present embodiment may also be applied to the furnace temperature setting adjustment work during the manufacturing process. During the manufacturing process, by periodically performing the furnace temperature setting adjustment work by the prediction technique according to the present embodiment, the furnace temperature setting can be updated to the furnace temperature setting that complements the decrease in the growth degree of the film thickness. Note that the furnace temperature setting adjustment work during such a manufacturing process may be performed by an event trigger (for example, when a decrease in the growth degree of the film thickness is detected, or when the yield rate of the product falls below a predefined threshold value) instead of or in addition to being periodically performed.

In the above description, a case where the prediction technique according to the present embodiment is applied to the prediction of the film thickness to be formed on the wafer in the diffusion furnace 200 has been described as an example. However, the present invention is not limited thereto. The prediction technique according to the present embodiment may be applied to a case where the target value changes every time, a case where a setting value is given to the controlled object 20 according to experience unique to the user, and the like.

For example, by using the prediction technique according to the present embodiment, when the temperature and humidity in the clean room are controlled to be constant using the air taken in from the outside air, target settings such as how much the temperature of the LPG gas should be raised and how much the LPG gas should be cooled with the cooling water may be proposed from the situation of the temperature and humidity change of the outside air.

For example, by using the prediction technique according to the present embodiment, the offset amount of the sensor, the current situation of the device, and the like may be learned at the time of calibrating the device, and the calibration may be performed with the recommended parameter setting adjustment amount. As an example, by using the prediction technique according to the present embodiment in calibrating a monitoring camera installed in a factory, focus, lens distortion, and the like may be predicted, and internal parameters of the monitoring camera may be adjusted by a setting adjustment amount recommended according to the prediction result.

In the above description, only a case where the prediction apparatus 100 uses indexes of a plurality of prediction values for output has been described, but the present invention is not limited thereto. The prediction apparatus 100 may use the indexes of the plurality of prediction values as evaluation criteria of the setting value T'. That is, when a plurality of setting values at which all of the plurality of prediction values satisfy a predefined reference are stored as setting value candidates, the evaluation unit 170 may select one setting value on the basis of the index. At this time, for example, when the indexes of the plurality of prediction values exceed a predefined threshold value, the evaluation unit 170 may exclude setting values corresponding to the plurality of prediction values from candidates of setting values to be recommended. The evaluation unit 170 may score the setting value on the basis of the plurality of prediction values and the indexes of the plurality of prediction values, and select the setting value having the highest score as the setting value to be recommended. In this case, the evaluation unit 170 may use a function in which the score becomes higher as the prediction value is closer to the designated value and the score becomes higher as the index is smaller.

Various embodiments of the present invention may also be described with reference to flowcharts and block diagrams, where the blocks may represent (1) a stage of processing in which an operation is performed or (2) a section of a device that is responsible for performing the operation. Certain stages and sections may be implemented by dedicated circuitry, programmable circuitry provided with computer readable instructions stored on a computer readable medium, and/or a processor provided with computer readable instructions stored on a computer readable medium. The dedicated circuitry may include digital and/or analog hardware circuits, and may include integrated circuits (ICs) and/or discrete circuits. The programmable circuitry may include reconfigurable hardware circuits including memory elements such as logic AND, logic OR, logic XOR, logic NAND, logic NOR, and other logic operations, flip-flops, registers, field programmable gate arrays (FPGA), programmable logic arrays (PLA), and the like.

The computer readable medium may include any tangible device capable of storing instructions for execution by a suitable device, so that the computer readable medium having the instructions stored therein will have a product including instructions that can be executed to create means for performing the operations designated in flowcharts or block diagrams. Examples of the computer readable medium may include an electronic storage medium, a magnetic storage medium, an optical storage medium, an electromagnetic storage medium, a semiconductor storage medium, and the like. More specific examples of the computer readable medium may include a floppy (registered trademark) disk, a diskette, a hard disk, a random access memory (RAM), a read-only memory (ROM), an erasable programmable read-only memory (EPROM or flash memory), an electrically erasable programmable read-only memory (EEPROM), a static random access memory (SRAM), a compact disc read-only memory (CD-ROM), a digital versatile disk (DVD), a Blu-ray (registered trademark) disk, a memory stick, an integrated circuit card, and the like.

The computer readable instructions may include source code or object code written in any combination of one or more programming languages, including assembler instructions, instruction-set-architecture (ISA) instructions, machine instructions, machine-dependent instructions, microcode, firmware instructions, state-setting data, or an object oriented programming language such as Smalltalk (registered trademark), JAVA (registered trademark), C++, or the like, and conventional procedural programming languages such as the "C" programming language or similar programming languages.

The computer readable instructions may be provided for a processor or programmable circuitry of a general purpose computer, special purpose computer, or other programmable data processing devices locally or via a wide area network (WAN) such as a local area network (LAN), the Internet, or the like, and execute the computer readable instructions to create means for executing the operations designated in flowcharts or block diagrams. Examples of the processor include a computer processor, a processing unit, a microprocessor, a digital signal processor, a controller, a microcontroller, and the like.

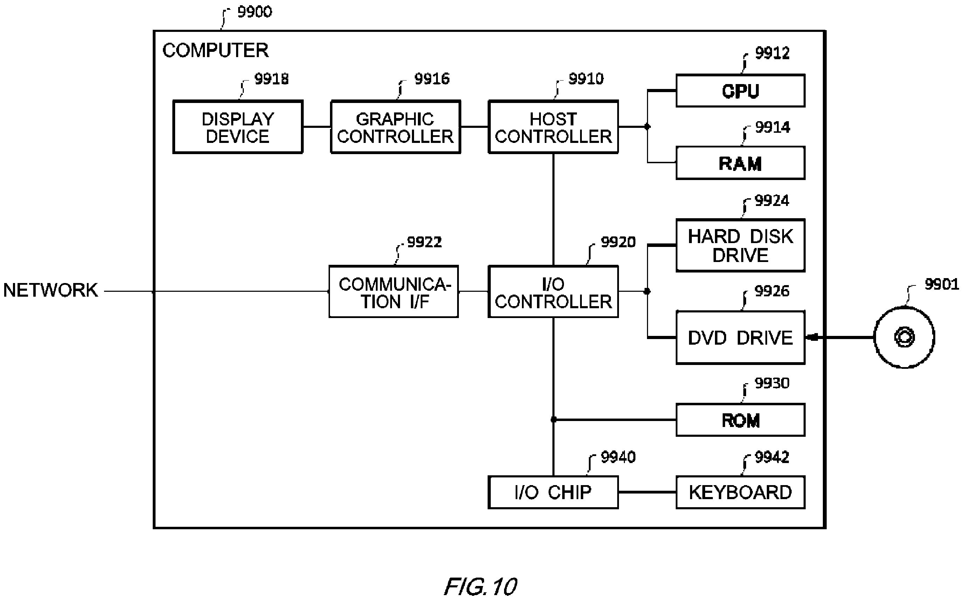

Fig. 10 illustrates an example of a computer 9900 in which a plurality of aspects of the present invention may be embodied in whole or in part. A program installed in the computer 9900 may cause the computer 9900 to function as an operation associated with the devices according to the embodiments of the present invention or as one or more sections of the devices, or may cause the operation or the one or more sections to be executed, and/or may cause the computer 9900 to execute a process according to the embodiments of the present invention or a stage of the process. Such programs may be executed by a CPU 9912 to cause the computer 9900 to perform certain operations associated with some or all of the blocks in the flowcharts and block diagrams described in the present specification.

The computer 9900 according to the present embodiment includes the CPU 9912, a RAM 9914, a graphic controller 9916, and a display device 9918, which are interconnected by a host controller 9910. The computer 9900 also includes input/output units such as a communication interface 9922, a hard disk drive 9924, a DVD drive 9926, and an IC card drive, which are connected to the host controller 9910 via an input/output controller 9920. The computer also includes legacy input/output units such as a ROM 9930 and a keyboard 9942, which are connected to the input/output controller 9920 via an input/output chip 9940.

The CPU 9912 operates according to programs stored in the ROM 9930 and the RAM 9914, thereby controlling each unit. The graphic controller 9916 acquires image data generated by the CPU 9912 in a frame buffer or the like provided in the RAM 9914 or in itself, such that the image data is displayed on the display device 9918.

The communication interface 9922 communicates with other electronic devices via a network. The hard disk drive 9924 stores programs and data used by the CPU 9912 in the computer 9900. The DVD drive 9926 reads a program or data from the DVD-ROM 9901 and provides the program or data to the hard disk drive 9924 via the RAM 9914. The IC card drive reads programs and data from the IC card, and/or writes programs and data to the IC card.

The ROM 9930 stores therein boot programs and the like executed by the computer 9900 at the time of activation, and/or programs that depend on the hardware of the computer 9900. The input/output chip 9940 may also connect various input/output units to the input/output controller 9920 via parallel ports, serial ports, keyboard ports, mouse ports, or the like.

The program is provided by a computer readable medium such as the DVD-ROM 9901 or the IC card. The program is read from a computer readable medium, installed in the hard disk drive 9924, the RAM 9914, or the ROM 9930 which are also examples of the computer readable medium, and executed by the CPU 9912. The information processing described in these programs is read by the computer 9900 and provides cooperation between the programs and various types of hardware resources. The device or method may be configured by implementing operations or processing of information according to use of the computer 9900.

For example, in a case where communication is performed between the computer 9900 and an external device, the CPU 9912 may execute a communication program loaded in the RAM 9914 and instruct the communication interface 9922 to perform communication processing on the basis of a process described in the communication program. Under the control of the CPU 9912, the communication interface 9922 reads transmission data stored in a transmission buffer processing area provided in a recording medium such as the RAM 9914, the hard disk drive 9924, the DVD-ROM 9901, or the IC card, transmits the read transmission data to the network, or writes reception data received from the network in a reception buffer processing area or the like provided on the recording medium.

In addition, the CPU 9912 may cause the RAM 9914 to read all or a necessary part of a file or database stored in an external recording medium such as the hard disk drive 9924, the DVD drive 9926 (DVD-ROM 9901), the IC card, or the like, and may execute various types of processing on data on the RAM 9914. Next, the CPU 9912 writes back the processed data to the external recording medium.

Various types of information such as various types of programs, data, tables, and databases may be stored in a recording medium and subjected to information processing. The CPU 9912 may execute various types of processing on the data read from the RAM 9914, including various types of operations, information processing, conditional determination, conditional branching, unconditional branching, information retrieval/replacement, and the like, which are described throughout the present disclosure and designated by a command sequence of a program, and writes back the results to the RAM 9914. In addition, the CPU 9912 may retrieve information in a file, a database, or the like in the recording medium. For example, in a case where a plurality of entries each having the attribute value of a first attribute associated with the attribute value of a second attribute is stored in the recording medium, the CPU 9912 may retrieve the plurality of entries for an entry matching the condition in which the attribute value of the first attribute is designated, read the attribute value of the second attribute stored in the entry, and thereby acquire the attribute value of the second attribute associated with the first attribute satisfying the predefined condition.

The programs or software modules described above may be stored in a computer readable medium on or near the computer 9900. In addition, a recording medium such as a hard disk or a RAM provided in a server system connected to a dedicated communication network or the Internet can be used as a computer readable medium, thereby providing a program to the computer 9900 via the network.

While the embodiments of the present invention have been described, the technical scope of the invention is not limited to the above described embodiments. It is apparent to persons skilled in the art that various alterations and improvements can be added to the above-described embodiments. It is also apparent from the scope of the claims that the embodiments added with such alterations or improvements can be included in the technical scope of the invention.

The operations, procedures, steps, and stages of each process performed by an apparatus, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order.

EXPLANATION OF REFERENCE NUMBERS

[0105]

10: facility
20: controlled object
100: prediction apparatus
110: data acquisition unit
120: feature amount extraction unit
130: learning unit
140: learning model storage unit
150: setting adjustment unit
160: prediction unit
170: evaluation unit
180: output unit
200: diffusion furnace
900: control apparatus
910: control unit
9900: computer
9901: DVD-ROM
9910: host controller
9912: CPU
9914: RAM
9916: graphic controller
9918: display device
9920: input/output controller
9922: communication interface
9924: hard disk drive
9926: DVD drive
9930: ROM
9940: Input/output chip
9942: keyboard

**Claims**

1. A prediction apparatus comprising:

   a data acquisition unit configured to acquire setting value data indicating a setting value of a controlled object and physical quantity data indicating a physical quantity of a product obtained by controlling the controlled object;
   a prediction unit configured to calculate, using the setting value data and the physical quantity data, a plurality of prediction values obtained by predicting a plurality of physical quantities in the product on a basis of a setting value used for control of the controlled object;
   an evaluation unit configured to evaluate the plurality of prediction values on a basis of a predefined reference; and
   an output unit configured to output a setting value recommended according to a result of the evaluation.

2. The prediction apparatus according to claim 1, wherein
   the prediction unit is configured to calculate the plurality of prediction values using a learning model generated by machine-learning a relationship between a setting value of the controlled object and a physical quantity of the product using the setting value data and the physical quantity data as learning data.

3. The prediction apparatus according to claim 2, further comprising:
   a learning unit configured to generate the learning model.

4. The prediction apparatus according to claim 3, further comprising:

   a feature amount extraction unit configured to extract a change rate of the setting value and a change rate of the physical quantity from the setting value data and the physical quantity data, wherein

the learning unit is configured to generate the learning model in which the change rate of the setting value is input and the change rate of the physical quantity is output.

5. The prediction apparatus according to claim 3 or 4, wherein
the learning unit is configured to generate the learning model by Gaussian process regression.

6. The prediction apparatus according to any one of claims 2 to 5, wherein
the prediction unit is further configured to calculate each of indexes indicating reliabilities of the plurality of prediction values on a basis of a standard deviation obtained by a probability model handled in the machine learning.

7. The prediction apparatus according to claim 6, wherein
the output unit is further configured to output each of the plurality of prediction values together with the index.

8. The prediction apparatus according to any one of claims 1 to 7, further comprising:

a setting adjustment unit configured to adjust a setting value in order to search for a setting value at which all of the plurality of prediction values satisfy the predefined reference, wherein
the output unit is configured to output the searched setting value as the recommended setting value.

9. The prediction apparatus according to any one of claims 1 to 8, wherein
the controlled object is a heater for adjusting a temperature in a furnace for heat-treating a wafer, and a physical quantity of the product is a film thickness to be formed on the wafer.

10. The prediction apparatus according to claim 9, wherein
the prediction unit is configured to predict a film thickness to be formed on each of a plurality of wafers disposed in the furnace.

11. A prediction method comprising:

acquiring setting value data indicating a setting value of a controlled object and physical quantity data indicating a physical quantity of a product obtained by controlling the controlled object;
calculating, using the setting value data and the physical quantity data, a plurality of prediction values obtained by predicting a plurality of physical quantities in the product on a basis of a setting value used for control of the controlled object;
evaluating the plurality of prediction values on a basis of a predefined reference; and
outputting a setting value recommended according to a result of the evaluating.

12. A prediction program that is executed by a computer to cause the computer to function as:

a data acquisition unit configured to acquire setting value data indicating a setting value of a controlled object and physical quantity data indicating a physical quantity of a product obtained by controlling the controlled object;
a prediction unit configured to calculate, using the setting value data and the physical quantity data, a plurality of prediction values obtained by predicting a plurality of physical quantities in the product on a basis of a setting value used for control of the controlled object;
an evaluation unit configured to evaluate the plurality of prediction values on a basis of a predefined reference; and
an output unit configured to output a setting value recommended according to a result of the evaluating.

13. A control apparatus comprising:
a control unit configured to control the controlled object according to the recommended setting value, in addition to the data acquisition unit, the prediction unit, the evaluation unit, and the output unit included in the prediction apparatus according to claim 1.

*FIG.1*

FURNACE
OPENING
(FRONT)

FURNACE
CENTER
(CENTER)

FURNACE
REAR
(REAR)

TUBE

WAFER

PROCESS
GAS

BOAT

THERMOCOUPLE

HEATER

HEATER
CONTROLLER

200    *FIG.2*

EP 4 095 625 A1

```
                        ┌─────────────┐
                        │    START    │
                        └──────┬──────┘
                               │
              ┌────────────────▼────────────────┐
   S310 ──────│  CLEAN TUBE, AND PERFORM         │
              │  REASSEMBLY                      │
              └────────────────┬────────────────┘
                               │
              ┌────────────────▼────────────────┐
   S320 ──────│  ADJUST FURNACE TEMPERATURE      │
              └────────────────┬────────────────┘
                               │
                               ◄───────────────────────────────┐
                               │                                │
              ┌────────────────▼────────────────┐               │
   S330 ──────│       DISPOSE WAFER              │               │
              └────────────────┬────────────────┘               │
                               │                                │
              ┌────────────────▼────────────────┐   ┌───────────┴────────────────────┐
   S340 ──────│       FORM FILM                  │   S370 ──│ ADJUST FURNACE TEMPERATURE│
              └────────────────┬────────────────┘   │        SETTING                  │
                               │                     └───────────▲────────────────────┘
              ┌────────────────▼────────────────┐                │
   S350 ──────│   MEASURE FILM THICKNESS         │                │
              └────────────────┬────────────────┘                │
                               │                                 │
                          ╱────▼────╲                            │
                         ╱   IS IT    ╲      No                  │
   S360 ────────────────◄ WITHIN REFERENCE ├─────────────────────┘
                         ╲   RANGE?   ╱
                          ╲────┬────╱
                               │ Yes
                        ┌──────▼──────┐
                        │     END     │
                        └─────────────┘
```

*FIG.3*

START

S410 — ACQUIRE LEARNING DATA

S420 — EXTRACT FEATURE AMOUNT

S430 — GENERATE LEARNING MODEL

S440 — STORE LEARNING MODEL

END

FIG.4

*FIG.5*

EP 4 095 625 A1

START

S610 — ACQUIRE DATA

S620 — ADJUST SETTING VALUE

S630 — EXTRACT FEATURE AMOUNT

S640 — PREDICT PHYSICAL QUANTITY OF PRODUCT

IS IT WITHIN REFERENCE RANGE?

S650 — ⟨ ⟩ No

Yes

S660 — STORE SETTING VALUE SATISFYING REFERENCE

S670 — ⟨ HAVE ALL PATTERNS BEEN EVALUATED? ⟩ No

Yes

S680 — OUTPUT
- RECOMMENDED SETTING VALUE
- PREDICTION VALUE, INDEX

END

*FIG.6*

FIG.7

<CURRENT FURNACE TEMPERATURE SETTINGS>

FURNACE OPENING TEMP-ERATURE Tf : 954.7°C    FURNACE CENTER TEMP-ERATURE Tc : 939.3°C    FURNACE REAR TEMP-ERATURE Tr : 950.3°C    FILM FORMATION TIME t : 3 MIN 27 SEC

+71.8°C         ±0°C         -5.2°C         +30 SEC

<RECOMMENDED FURNACE TEMPERATURE SETTINGS>

FURNACE OPENING TEMP-ERATURE Tf' : 1026.5°C    FURNACE CENTER TEMP-ERATURE Tc' : 939.3°C    FURNACE REAR TEMP-ERATURE Tr' : 945.1°C    FILM FORMATION TIME t' : 3 MIN 57 SEC

<PREDICTION VALUE AND INDEX>

PREDICTION VALUE OF FILM THICKNESS

95% CONFIDENCE INTERVAL

UPPER LIMIT VALUE

DESIGNATED VALUE

LOWER LIMIT VALUE

FILM THICKNESS [Å]

WAFER POSITION

*FIG.8*

EP 4 095 625 A1

FIG.9

FIG.10

Europäisches
Patentamt

European
Patent Office

Office européen
des brevets

## EUROPEAN SEARCH REPORT

Application Number

**EP 22 17 3952**

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2021/002108 A1 (FUJIFILM CORP [JP]) 7 January 2021 (2021-01-07) * abstract * & US 2022/066399 A1 (HASEGAWA MASATAKA [JP]) 3 March 2022 (2022-03-03) * paragraphs [0002], [0035], [0044] – [0054], [0060], [0069], [0073] – [0082], [0094] – [0096]; figures 1,7-9 * ----- | 1-13 | INV. G05B13/02 G05B13/04 |

TECHNICAL FIELDS
SEARCHED      (IPC)

G05B

The present search report has been drawn up for all claims

| Place of search | Date of completion of the search | Examiner |
|---|---|---|
| The Hague | 6 October 2022 | Bassi, Luca |

EPO FORM 1503 03.82 (P04C01)

## ANNEX TO THE EUROPEAN SEARCH REPORT
## ON EUROPEAN PATENT APPLICATION NO.

EP 22 17 3952

This annex lists the patent family members relating to the patent documents cited in the above-mentioned European search report.
The members are as contained in the European Patent Office EDP file on
The European Patent Office is in no way liable for these particulars which are merely given for the purpose of information.

06-10-2022

| Patent document cited in search report | | Publication date | Patent family member(s) | | Publication date |
|---|---|---|---|---|---|
| WO 2021002108 | A1 | 07-01-2021 | CN 113994281 | A | 28-01-2022 |
| | | | EP 3995917 | A1 | 11-05-2022 |
| | | | JP WO2021002108 | A1 | 07-01-2021 |
| | | | US 2022066399 | A1 | 03-03-2022 |
| | | | WO 2021002108 | A1 | 07-01-2021 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 61120427 A